# EUROPEAN PATENT SPECIFICATION

(11) **EP 0 356 033 B1**
(45) Date of publication and mention of the grant of the patent: **24.11.1993**
(21) Application number: 89307778.4
(22) Date of filing: 31.07.1989
(51) Int. Cl.: H01L 31/042, H01L 31/05

(54) **Solar cell device**
Sonnenzelle
Cellule solaire

(30) Priority: 26.08.1988 JP 212905/88
(43) Date of publication of application: 28.02.1990
(73) Proprietor: MITSUBISHI DENKI KABUSHIKI KAISHA, Tokyo 100 (JP)
(72) Inventor: Matsumoto, Hideo c/o Mitsubishi Denki K. K., Itami-shi Hyogo-ken (JP); Hokuyo, Shigeru c/o Mitsubishi Denki K. K., Itami-shi Hyogo-ken (JP)
(74) Representative: Beresford, Keith Denis Lewis

(56) References cited:
- DE-A- 3 627 641
- GB-A- 1 333 593
- US-A- 4 340 803
- PATENT ABSTRACTS OF JAPAN, vol. 11, no. 367 (E-561)[2814], 28th November 1987;& JP-A-62 139 362
- THE CONFERENCE RECORD OF THE 19TH IEEE PHOTOVOLTAIC SPECIALISTS CONFERENCE-1987, New Orleans, Louisana, 4th - 8th May 1987, pages 448-453, IEEE, New York, US; B.S. SMITH et al.: "GaAs solar cell circuit assembly"

## Description

### FIELD OF THE INVENTION

The present invention relates to a solar cell device, and more particularly to that in which a plurality of solar cell elements are connected by interconnectors.

### BACKGROUND OF THE INVENTION

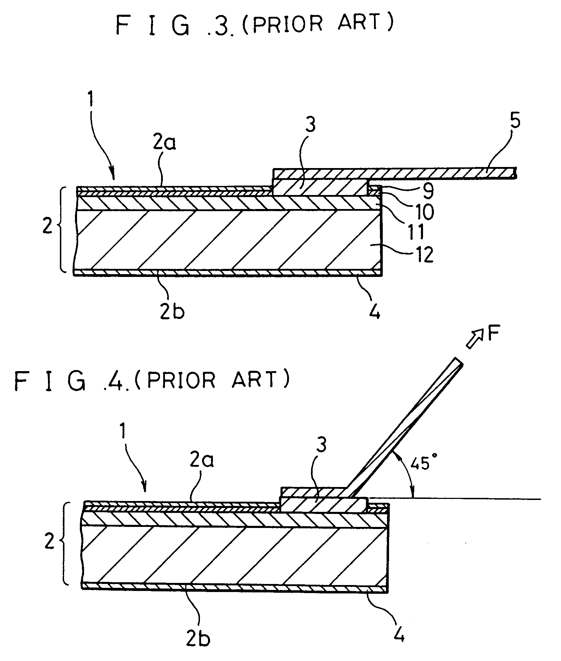

Figure 3 shows a cross section of a prior art solar cell in which a plurality of solar cell elements are connected by interconnectors.

In Figure 3, reference numeral 1 designates a solar cell device and reference numeral 2 designates a solar cell element. The solar cell element 2 has a light receiving surface 2a and a rear surface 2b. An electrode 3 is provided at the side of light receiving surface 2a and an electrode 4 is provided at the side of rear surface 2b. An interconnector 5 comprising Ag is provided on the electrode 3. A p type GaAs layer 11 and an n type GaAs layer 12 constitute a pn junction. A p type AlGaAs contact layer 10 is provided on the p type GaAs layer 11. A reflection preventing film 9 comprising such as Si₃N₄ is provided on the p type AlGaAs layer.

When light is incident via the light receiving surface 2a to the solar cell element 2 thus produced, the incident light generates photo carriers in the p type AlGaAs layer 10, p type GaAs layer 11, and n type GaAs layer 12, thereby generating an electromotive force in the solar cell element 2. Thus generated electromotive force is output to the outside of the solar cell element 1 via the electrodes 3 and 4. Herein, in order to obtain a desired output, it is required to interconnect external connection electrodes provided at a portion of the light receiving section of the respective solar cell element 1 by using interconnectors 5.

Conventionally, as a method for junctioning the interconnector 5 to the external connection electrode 3, soft soldering is mainly used. However, in using a solar cell device in which a plurality of solar cell elements are mutually connected by interconnectors 5 while mounting on such as an artificial satellite, due to a wide range of change in the surrounding temperature of the solar cell, the solder layer which is put between by the interconnector 5 and the electrode 3 is subjected to stresses by heat cycle and the solder itself is decomposed, thereby arising variation in the resistance at the junction portion and reduction in the mechanical strength.

In order to avoid these problems, a method of junctioning the electrode 3 and the interconnector 5 by direct welding is adopted. As a method of direct welding, a method called as a parallel gap soldering is generally used and it is desired that it should not give influences on the element characteristics at the welding, i.e., that reduction in the output due to leakage at the junction portion should not arise and that the mechanical strength of the junction portion should be higher than the element strength. A method for interconnecting solar cells by means of parallel gap welding is known from US-A-4340803.

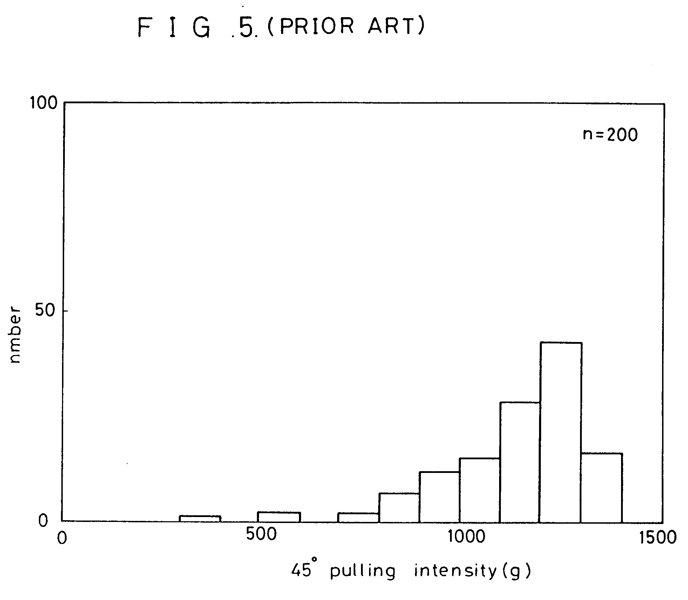

In the prior art solar cell thus constructed, 45 degree pull strength distribution of the welding portion which is obtained after the welding of interconnector 5 is shown in Figure 5. Herein, the 45 degree pull strength means the magnitude of force when the interconnector 5 is separated from the electrode 3 while the interconnector 5 is pulled up in the direction of F shown in the figure with holding the interconnector 5 in a direction of 45 degree from the junction surface of the interconnector 5 and the electrode 3.

As a result of this experiment, it has been evidenced that the bond strength is distributed to have variations as shown in Figure 5, and there exists one which has quite a low intensity. The main cause of such variations in bond strength is thought to be concentration of force. That is, since the p type GaAs layer 11 and the p type AlGaAs layer 10 are grown by liquid phase epitaxy, the surface of the solar cell 2 is likely to have a corrugation, and the electrode surface of the element does not always become flat and the boundary of the welding between the electrode 3 and the interconnector 5 does not come in a straight line.

Accordingly, when a pulling force is applied to such welding portion, the force is thought to be mainly applied to the boundary of the welding of the interconnector 5 and the electrode 3. Then, a various kinds of distribution of applied force may are thought of. In quite an extreme case, the force may be concentrated on quite a small area. In such a case, even when the junction intensity between element and electrode is kept uniform, the force is concentrated on a narrow area and the welding intensity between the interconnector 5 and the electrode 3 shows a low value. Accordingly, as a method of solving the above described problems, the following three methods are thought of.
(1) To enhance the bond strength between the solar cell device 1 and the electrode 3
(2) To make flat the surface of electrode 3, and
(3) To enhance the strength of the electrode 3 itself.

However, all of these methods have following problems, which result in difficulty in realization.

As the first method which attempts to enhance the bond strength between the element 1 and the external connection electrode 3, generally, a method of conducting mutual diffusion by using the method of such as sintering can be thought of. However, in the application to the solar cell, the depth up to the pn junction between p type GaAs layer 11 and n type GaAs layer 12 from the light receiving surface 2a is made shallow so as to enable to sufficiently collect photocarriers even if the diffusion length of photocarriers is reduced due to crystal defects generated by the radiation exposure. Therefore, when the temperature is raised by such as sintering in an element of such structure, Ti or Pd constituting the electrode 3 may enter into the light electricity conversion section, thereby occurring leakage at the pn junction, resulting in deterioration in the element characteristics.

The above-described second method which attempts to flatten the uneven surface of electrode 3 has also difficulty as in the following. Because the p type AlGaAs layer 10 and the p type GaAs layer 11 below the electrode 3 are produced by liquid phase epitaxy, their surface becomes uneven. This results in difficulty in flattening the surface electrode 3 which will be produced thereon.

In the above described third method which attempts to enhance the strength of the electrode itself, it is necessary to increase the thickness of electrode 3 on the condition that the same material is used for the electrode 3, and the stress which is applied to the element is also increased with increasing electrode thickness, whereby unfavourable mechanical and electrical influences on the solar cell device arise.

### SUMMARY OF THE INVENTION

An object of the present invention is to provide a solar cell device having a high and stable bond strength between solar cell element and interconnectors.

Other objects and advantages of the present invention will become apparent from the detailed description given hereinafter; it should be understood, however, that the detailed description and specific embodiment are given by way of illustration only.

According to the present invention, while connecting a plurality of solar cell elements by interconnectors, a metal film is inserted between the electrodes of the solar cell element and interconnector, and the welding area between the metal film and the electrode is made larger than the welding area between the metal film and the interconnector. Accordingly, the force applied to the electrode of the element from the interconnector is diversified by the metal film, and the metal film functions as a buffer layer, thereby preventing concentrations of force onto a point of the element electrode, resulting in a stable welding intensity.

### BRIEF DESCRIPTION OF THE DRAWINGS

Figure 1(a) is a plan view of a solar cell according to an embodiment of the present invention;
Figure 1(b) is a Ib-Ib cross sectional view of the solar cell of Figure 1(a);
Figure 1(c) is a perspective view of the solar cell of Figure 1(a);
Figure 2 is a diagram showing 45 degree pull strength distribution between the external connection electrode and the interconnector of the solar cell element of the embodiment of Figure 1;
Figure 3 is a cross sectional view showing a prior art solar cell;
Figure 4 is a diagram showing a manner of experiment of the 45 degree pull strength intensity of the prior art solar cell; and
Figure 5 is a diagram showing a 45 degree pull strength distribution between the external connection electrode and interconnector of the prior art solar cell.

### DETAILED DESCRIPTION OF THE PREFERRED EMBODIMENTS

An embodiment of the present invention will be described in detail with reference to the drawings.

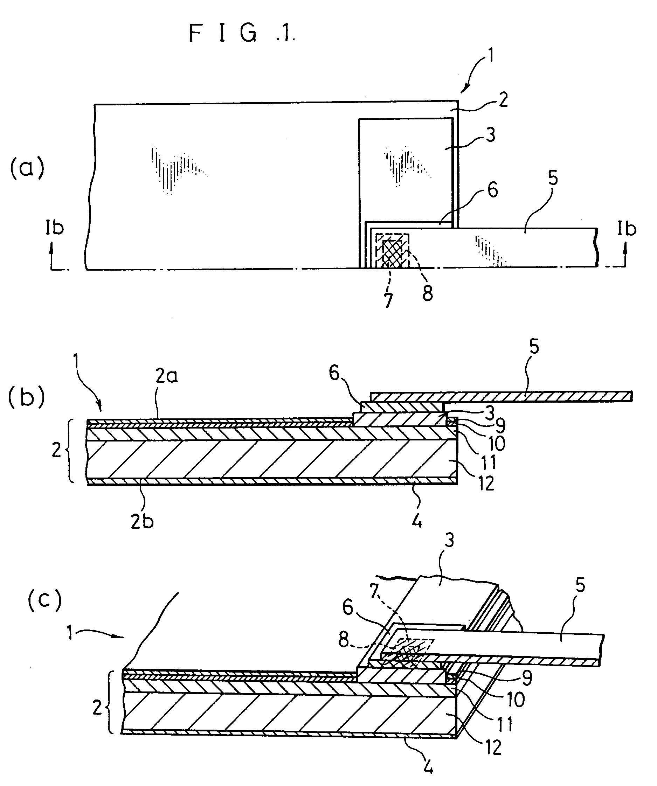

Figure 1(a) shows a plan view of a solar cell according to an embodiment of the present invention and Figure 1(b) and (c) show Ib-Ib cross sectional view and perspective view thereof, respectively. In Figure 1, the same reference numerals designate the same or corresponding elements as those shown in Figure 3. An Ag film 6 is provided between the external connection electrode 3 and the interconnector 5. Reference numeral 7 designates welding portion between the interconnector 5 and Ag film 6 and reference numeral 8 designates welding portion between the Ag film 6 and the electrode 3.

The production method of this embodiment will be described.

On an n type GaAs layer 12 of about 180 micrometers to 300 micrometers thickness, a p type GaAs layer 11 of about 0.5 micrometer and a p type AlGaAs layer 10 of about 50nm (500 Angstroms) are successively grown by liquid phase epitaxy. Subsequently, a reflection preventing film 9 comprising Si₃N₄ is provided on the surface of p type AlGaAs layer 10 by CVD (Chemical Vapor Deposition) or sputtering, and thereafter contact holes are apertured by etching on this reflection preventing film 9 and p type AlGaAs layer 10. An electrode 3 as an external connection electrode comprising Ti(50nm)/Pd(5nm)/Ag(4 to 5 micrometers) is produced at the contact holes by vapor deposition or sputtering, and an electrode 4 comprising Au-Ge/Ni/Au (thickness of three layers amounts to about 1 micrometer)/Ag(4 to 5 micrometers) is produced at the rear surface 2b of the solar cell.

Next, the solar cell element 1 and the interconnector 5 are welded by a parallel gap soldering method. In connecting a plurality of solar cells, firstly, an Ag film 6 having thickness of at least 5 micrometers, preferably 10 to 50 micrometers is welded onto the electrode 3 of element, and thereafter an interconnector 5 is welded onto this Ag film 6. Herein, the welding portion 8 between the electrode 3 and Ag film 6 is larger than the welding portion 7 between the interconnector 5 and Ag film 6, and the area ratio of them is about 3 to 1.

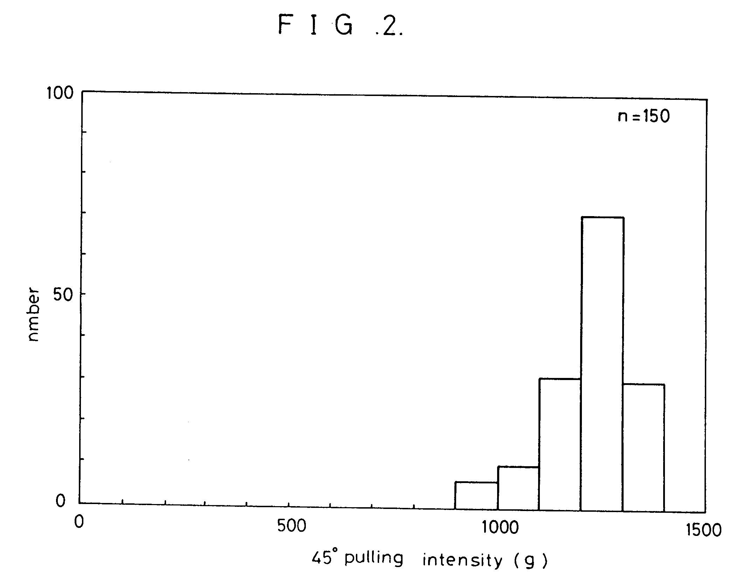

Figure 2 shows the result of 45 degree pull strength experiment of the welding portion between the electrode 3 and the interconnector of a solar cell according to an embodiment of the present invention. The method of experiment is the same as that described with respect to the prior art. As seen from the figure, the intensity distribution in case where Ag film 6 is previously welded shows quite a high intensity concentration, showing high stability. That is, as shown in Figure 1, by welding the Ag film 6 and the electrode 3 at an area wider than the welding area between the interconnector 5 and Ag film 6, the force from the interconnector 5 can be diversified by the Ag film 6. Accordingly, the force which is applied to the welding portion of the electrode 3 of the element can be also diversified, thereby heightening the bond strength between the element and the interconnector 5, resulting in showing high stability.

While in the above illustrated embodiment an Ag film is employed for the metal film 6 which is to be provided between the electrode 3 and the interconnector 5, this metal film may comprise such as Au film, with the same effects as described above.

As discussed above, according to the present invention, a metal film is inserted between the external connection electrode and the interconnector of the solar cell device and the welding area between the metal film and the electrode is made larger than the welding area between the metal film and the interconnector. Therefore, in case where there are problems in the junction intensity and surface state of the element electrode, a strong and stable bond strength between the solar cell element and interconnector is obtained, thereby providing a high reliability solar cell.

## Claims

1. A solar cell device in which a plurality of solar cell elements (2) provided with electrodes (3) are connected by
means of interconnectors (5), wherein a metal film (6) is provided between one electrode (3) of each solar cell element (2) and the corresponding interconnector (5),
the welding area (8) between said metal film (6) and said electrode (3) being larger than the welding area (7) between said metal film (6) and said interconnector (5).

2. A solar cell device as defined in claim 1, wherein said metal film comprises Ag film.

3. A solar cell device as defined in claim 1, wherein said metal film comprises Au film.

4. A solar cell device as defined in claim 1, wherein the film thickness of said metal film is at least 5 micrometers and preferably 10 to 50 micrometers.

5. A solar cell device as defined in claim 1, wherein the electrode of said solar cell element comprises Ti/Pd/Ag.

6. A solar cell device as defined in claim 1, wherein the ratio of welding areas between the metal film and electrode and the welding area between the metal film and interconnector is about 3 to 1.

7. A method of manufacturing a solar cell device as defined in claim 1, wherein the welding between said metal film and electrode and the welding between said metal film and interconnector are conducted by parallel gap soldering method.

## Patentansprüche

1. Solarzelle (1), in der eine Vielzahl von mit Elektroden (3) ausgestatteten Solarzellelementen (2) mittels Verbindungsleitungen (5) verbunden sind, wobei
ein Metallfilm (6) zwischen einer Elektrode (3) jedes Solarzellelements (2) und der entsprechenden Verbindungsleitung (5) angeordnet ist und
die Schweißfläche (8) zwischen dem Metallfilm (6) und der Elektrode (3) größer ist als die Schweißfläche (7) zwischen dem Metallfilm (6) und der Verbindungsleitung (5).

2. Solarzelle nach Anspruch 1, wobei der Metallfilm aus einem Ag-Film besteht.

3. Solarzelle nach Anspruch 1, wobei der Metallfilm aus einem Au-Film besteht.

4. Solarzelle nach Anspruch 1, wobei die Filmdicke des Metallfilms mindestens 5 µm und vorzugsweise 10 bis 50 µm beträgt.

5. Solarzelle nach Anspruch 1, wobei die Elektrode des Solarzellelementes Ti/Pd/Ag enthält.

6. Solarzelle nach Anspruch 1, wobei das Verhältnis der Schweißfläche zwischen dem Metallfilm und der Elektrode zu der Schweißfläche zwischen dem Metallfilm und der Verbindungsleitung etwa 3 zu 1 beträgt.

7. Verfahren zur Herstellung einer Solarzelle nach Anspruch 1, wobei das Schweißen zwischen dem Metallfilm und der Elektrode und das Schweißen zwischen dem Metallfilm und der Verbindungsleitung durch ein Parallelspalt-Lötverfahren erfolgt.

## Revendications

1. Cellule solaire (1) dans laquelle un ensemble d'éléments de cellule solaire (2) comportant des électrodes (3) sont connectés au moyen de structures d' interconnexion (5), dans laquelle :
une pellicule de métal (6) est placée entre une électrode (3) de chaque élément de cellule solaire (2) et la structure d' interconnexion correspondante (5),
la zone de soudage (8) entre cette pellicule de métal (6) et l'électrode (3) étant plus grande que la zone de soudage (7) entre la pellicule de métal (6) et la structure d' interconnexion (5).

2. Cellule solaire définie dans la revendication 1, dans laquelle la pellicule de métal consiste en une pellicule d'Ag.

3. Cellule solaire définie dans la revendication 1, dans laquelle la pellicule de métal consiste en une pellicule d'Au.

4. Cellule solaire définie dans la revendication 1, dans laquelle l'épaisseur de la pellicule de métal est au moins de 5 micromètres, et de préférence de 10 à 50 micromètres.

5. Cellule solaire définie dans la revendication 1, dans laquelle l'électrode de l'élément de cellule solaire consiste en Ti/Pd/Ag.

6. Cellule solaire définie dans la revendication 1, dans laquelle le rapport entre les aires de la zone de soudage entre la pellicule de métal et l'électrode et de la zone de soudage entre la pellicule de métal et la structure d'interconnexion, est d'environ 3 à 1.

7. Procédé de fabrication d'une cellule solaire définie dans la revendication 1, dans lequel le soudage entre la pellicule de métal et l'électrode et le soudage entre la pellicule de métal et la structure d' interconnexion sont effectués par le procédé de brasage parallèle par capillarité.
